# EUROPEAN PATENT APPLICATION

(11) **EP 2 797 083 A1**
(43) Date of publication of application: **29.10.2014**
(21) Application number: 13005721.9
(22) Date of filing: 09.12.2013
(51) Int. Cl.: H01B 1/22, H01L 31/0224

(54) **Paste composite for forming electrode of solar cell**

(30) Priority: 25.04.2013 KR 20130045800
(71) Applicant: LG Electronics, Inc., Seoul, 150-721 (KR)
(72) Inventor: Chae, Myunghyun, 137-724 Seoul (KR); Lee, Jinhan, 137-724 Seoul (KR); Jung, Yongjun, 137-724 Seoul (KR)
(74) Representative: Frenkel, Matthias Alexander

(57) **Abstract**

Discussed is a paste composite for forming an electrode of a solar cell including a conductive powder, a glass frit, and an organic vehicle, wherein the conductive powder is present in an amount of 50 parts by weight or less, with respect to 100 parts by weight of the paste composite in total, and the conductive powder has a mean particle diameter of 0.3 *µ*m to 1.0 *µ*m.

## Description

### CROSS-REFERENCE TO RELATED APPLICATION

This application claims the priority benefit of Korean Patent Application No. 10-2013-0045800, filed on April 25, 2013 in the Korean Intellectual Property Office, the disclosure of which is incorporated herein by reference.

### BACKGROUND OF THE INVENTION

### 1. Field of the invention

The embodiments of the invention relates to a paste composite, and more specifically, to a paste composite for forming an electrode of solar cells.

### 2. Description of the Related Art

Recently, conventional energy resources such as petroleum or coal are becoming depleted and interest in alternative energy sources replacing these resources has thus increased. Among such alternative energy sources, solar cells are attracting much attention as next-generation devices which convert solar energy into electrical energy.

Such a solar cell is manufactured by forming various layers and electrodes according to various designs. Efficiency of solar cells may be determined according to the designs of various layers and electrodes. Low efficiency should be overcome so as to put solar cells to practical use. Accordingly, efficiencies of solar cells should be maximized by improving properties of the various layers and electrodes.

In this regard, when an amount of a conductive powder of a paste composite for an electrode is increased in order to form an electrode with superior properties, a problem of cost increase occurs. When the amount of conductive powder is decreased in consideration of cost, problems of deterioration in resistance, and covering properties and the like occur.

### SUMMARY OF THE INVENTION

Therefore, the embodiments of the invention has been made in view of the above problems, and it is an object of the embodiments of the invention to provide a paste composite for forming an electrode of solar cells which exhibits superior properties and is prepared at reduced cost.

In accordance with an aspect of the embodiments of the invention, the above and other objects can be accomplished by the provision of a paste composite for forming an electrode of a solar cell including a conductive powder, a glass frit, and an organic vehicle, wherein the conductive powder is present in an amount of 50 parts by weight or less, with respect to 100 parts by weight of the paste composite in total, and the conductive powder has a mean particle diameter of 0. 3 µm to 1.0 µm.

### BRIEF DESCRIPTION OF THE DRAWINGS

The above and other objects, features and other advantages of the embodiments of the invention will be more clearly understood from the following detailed description taken in conjunction with the accompanying drawings, in which:
FIG. 1 is a perspective view illustrating a solar cell module including solar cells according to one embodiment of the present invention;
FIG. 2 is a sectional view taken along line II-II of the solar cell module of FIG. 1;
FIG. 3 is a partial sectional view taken along line III-III of one solar cell in the solar cell module of FIG. 1;
FIG. 4 is a scanning electron micrograph illustrating cross-sections of a semiconductor substrate and a rear electrode in accordance with Example 2;
FIG. 5 is a scanning electron micrograph illustrating cross-sections of a semiconductor substrate and a rear electrode in accordance with Example 3;
FIG. 6 is a scanning electron micrograph illustrating cross-sections of a semiconductor substrate and a rear electrode in accordance with Comparative Example 2; and
FIG. 7 is a scanning electron micrograph illustrating cross-sections of a semiconductor substrate and a rear electrode in accordance with Comparative Example 3.

### DETAILED DESCRIPTION OF THE EMBODIMENTS

Reference will now be made in detail to the embodiments of the present invention, examples of which are illustrated in the accompanying drawings. The embodiments of the invention are not limited to the embodiments and the embodiments may be modified into various forms.

In the drawings, parts obscuring a clear understanding of the description are not illustrated for clear and brief description of the embodiments of the invention, and the same reference numbers will be used throughout the specification to refer to the same or like parts. In the drawings, the thickness or size may be exaggerated or minimized for a more clear description. Also, the size or area of each constituent element is not limited to that illustrated in the drawings.

It will be further understood that, throughout this specification, when one element is referred to as "comprising" another element, the term "comprising" specify the presence of another element but' does not preclude the presence of another element, unless context clearly indicates otherwise. In addition, it will be understood that when one element such as a layer, a film, a region or a plate is referred to as being "on" another element, the one element may be directly on the another element, and one or more intervening elements may also be present. In contrast, when one element such as a layer, a film, a region or a plate is referred to as being "directly on" another element, one or more intervening elements are not present.

Hereinafter, a solar cell, a method for manufacturing the same and a paste composite for forming an electrode of the solar cell according to embodiments of the present invention will be described in detail with reference to the annexed drawings. First, a solar cell module including a solar cell will be described, a structure of the solar cell will then be described, and a paste composite for forming an electrode of the solar cell used for the solar cell will then be described in detail.

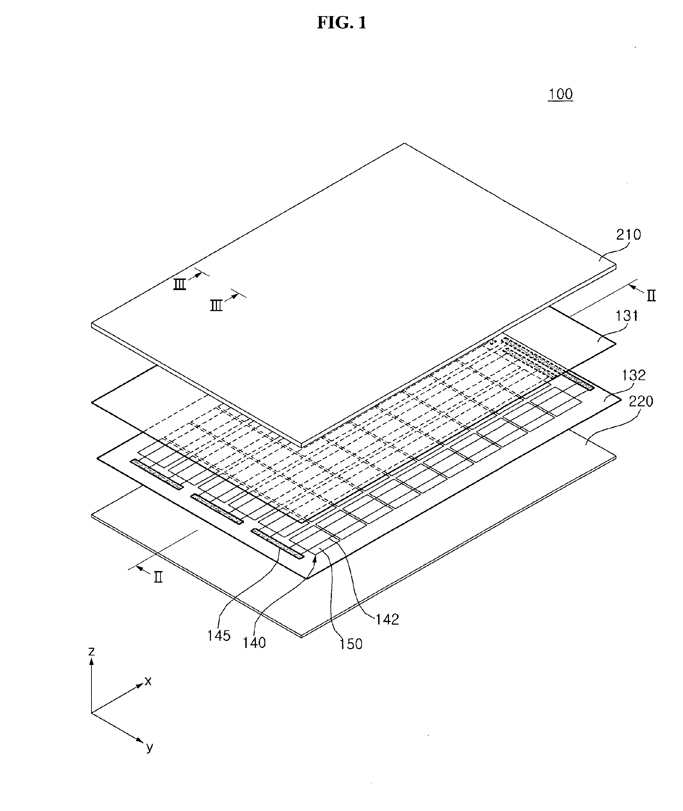

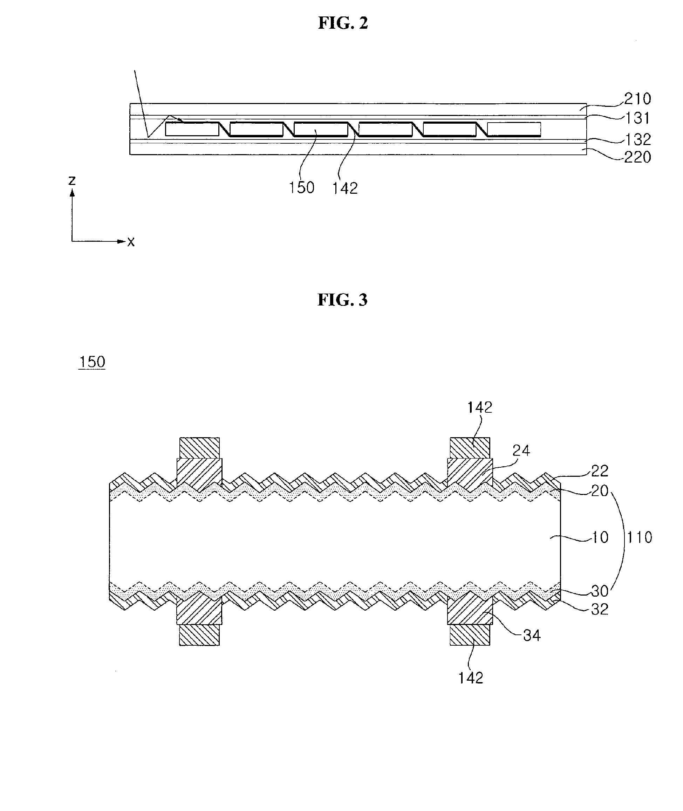

FIG. 1 is a perspective view illustrating a solar cell module including a solar cell according to one embodiment of the present invention, and FIG. 2 is a sectional view taken along line II-II of the solar cell module of FIG. 1.

Referring to FIGS. 1 and 2, the solar cell module 100 according to one embodiment of the present invention includes a solar cell 150, a front substrate 210 disposed on a front surface of the solar cell 150 and a rear sheet 220 disposed on a rear surface of the solar cell 150. In addition, the solar cell module 100 may include a first sealing material 131 interposed between the solar cell 150 and the front substrate 210, and a second sealing material 132 interposed between the solar cell 150 and the rear sheet 220.

For example, in the embodiment of the invention, a silicon solar cell obtained by forming a p- and/or n-type impurity layer on a semiconductor substrate (represented by reference numeral 110 in FIG. 3) made of silicon may be used as the solar cell 150. The silicon solar cell will be described in detail with reference to FIG. 3. The embodiments of the invention are not limited to the silicon solar cell. Accordingly, the solar cell 150 may have various structures such as compound semiconductor solar cells, tandem solar cells and dye-sensitized solar cells.

A plurality of solar cells including the solar cell 150 are electrically connected in series, in parallel and in series-parallel by a ribbon 142 to constitute a solar cell string 140. For example, as shown in FIG. 2, the ribbon 142 may connect a first electrode (represented by reference numeral 24 in FIG. 3, front electrode) formed on the front surface of one solar cell 150 to a second electrode (represented by reference numeral 34 in FIG. 3, rear electrode) formed on the rear surface of adjacent another solar cell 150 by a tabbing process. The tabbing process may be carried out by applying flux to a surface of the solar cell 150, placing the ribbon 142 on the flux-applied solar cell 150 and performing a baking process. The flux functions to remove an oxide film which interrupts soldering and is not necessarily present permanently.

In addition, a conductive film is adhered between one surface of the solar cell 150 and the ribbon 142 and the plurality of solar cells 150 are connected in series or parallel by thermal compression. The conductive film may have a structure in which conductive particles comprising gold, solver, nickel, copper or the like having superior conductivity are dispersed in a film made of an epoxy resin, an acrylic resin, a polyimide resin, a polycarbonate resin or the like. When such a conductive film is compressed while heat is applied thereto, the conductive particles are exposed to the outside of the film and the solar cell 150 is electrically connected to the ribbon 142 through the exposed conductive particles. In a case in which modulation is performed by connecting the plurality of solar cells 150 through the conductive film, process temperature is decreased and bending of the solar cells 150 is thus prevented or reduced.

In addition, a bus ribbon 145 alternatively connects both ends of the ribbon 142 of the solar cell string 140 and thereby electrically connects the solar cell strings 140. The bus ribbon 145 may be disposed in a direction crossing a length direction of the solar cell string 140 at the end of the solar cell string 140. Such a bus ribbon 145 is connected to a junction box which collects electricity generated by the solar cell 150 and prevents backflow of electricity.

The first sealing material 131 is disposed on a light-receiving surface of the solar cell 150, while the second sealing material 132 is disposed on the rear surface of the solar cell 150. The first sealing material 131 and the second sealing material 132 are adhered to each other by lamination, blocking penetration of moisture or oxygen which may have negative effects on the solar cell 150 and enabling chemical bonding between respective elements of the solar cell 150.

The first sealing material 131 and the second sealing material 132 may comprise an ethylene vinyl acetate (EVA) copolymer resin, a polyvinyl butyral resin, a silicone resin, an ester resin, an olefin resin or the like.

However, the embodiments of the invention are not limited to the formation method of the first and second sealing materials. Accordingly, the first and second sealing materials 131 and 132 may be formed by a method other than lamination, using various materials.

The front substrate 210 is disposed on the first sealing material 131 such that sunlight passes therethrough, and may be reinforced glass so as to protect the solar cell 150 from external impact or the like. In addition, the front substrate 210 may be low iron reinforced glass containing a small amount of iron so as to prevent or reduce reflection of sunlight and improve transmission of sunlight.

The rear sheet 220 is a layer which protects the solar cell 150 at the rear surface thereof and has waterproofing, insulation and UV blocking functions. The rear sheet 220 may be of a Tedlar/PET/Tedlar (TPT) type, but the embodiments of the invention are not limited thereto. In addition, the rear sheet 220 may be made of a material having superior reflectivity so as to reflect sunlight emitted from the front substrate 210 and reuse the same. However, the embodiments of the invention are not limited in terms of material, and the rear sheet 220 is made of a transparent material which admits incidence of sunlight and thus implements a double-surface solar cell module 100.

Hereinafter, a structure of the solar cell 150 will be described in detail with reference to FIG. 3.

FIG. 3 is a partial sectional view taken along line III-III of one solar cell in the solar cell module of FIG. 1.

Referring to FIG. 3, the solar cell 150 according to the embodiment of the invention includes a substrate 110 (for example, semiconductor substrate, hereinafter, referred to as a "semiconductor substrate"), impurity layers 20 and 30 formed on the semiconductor substrate 110, and electrodes 24 and 34 electrically connected to the impurity layers 20 and 30, respectively. The impurity layers 20 and 30 may include an emitter layer 20 and an electric field layer 30, and the electrodes 24 and 34 may include a first electrode 24 electrically connected to the emitter layer 20 and a second electrode 34 electrically connected to the electric field layer 30. The solar cell 150 may further include an anti-reflective film 22, a passivation film 32 and the like. The ribbon 142 enabling connection to another solar cell 150 is disposed on the electrodes 24 and 34. This will be described in more detail.

The semiconductor substrate 110 includes a region where the impurity layers 20 and 30 are formed, and a base region which is a region where the impurity layers 20 and 30 are not formed. The base region 10 may comprise, for example, silicon comprising a first conductivity type impurity. The silicon may be monocrystalline silicon or polycrystalline silicon, and the first conductivity type impurity is for example an n- or p-type impurity. That is, the base region 10 may be formed of monocrystalline or polycrystalline silicon doped with a Group V element such as phosphorus (P), arsenic (As), bismuth (Bi) or antimony (Sb). Alternatively, the base region 10 may be formed of monocrystalline or polycrystalline silicon doped with a Group III element such as boron (B), aluminum (Al), gallium (Ga) or indium (In).

The front and rear surfaces of the semiconductor substrate 110 may have irregularities formed by texturing. The irregularities formed by texturing are, for example, formed along a specific surface of a semiconductor constituting the semiconductor substrate 110 (for example, in the case of silicon, surface (111)). As a result, the irregularities formed by texturing may have, for example, a pyramidal shape.

The irregularities formed on the front and rear surfaces of the semiconductor substrate 110 by texturing increase surface roughness and thereby reduce reflection of light incident through the front and rear surfaces of the semiconductor substrate 110. Accordingly, an amount of light which reaches a p-n junction formed at the boundary between the semiconductor substrate 110 and the emitter layer 20 is increased and light loss is thus minimized.

The emitter layer 20 comprising a second conductivity type impurity may be formed on the front surface of the semiconductor substrate 110. In the embodiment of the invention, the emitter layer 20 has a second conductivity type impurity opposite to the semiconductor substrate 110. Specific examples of the Group III or V elements have been described with respect to the semiconductor substrate 110 and explanation thereof is thus omitted.

FIG. 3 illustrates that the emitter layer 20 has a structure in which a doping concentration of the second conductivity type impurity is predominantly homogeneous. However, the embodiments of the invention are not limited to this structure and the emitter layer 20 may have a selective structure including a high-concentration doping region and a low-concentration doping region. Other variations in the structure of the emitter layer are possible.

The anti-reflective film 22 and the first electrode 24 are formed on the semiconductor substrate 110, more specifically, on the emitter layer 20 formed on the semiconductor substrate 110.

The anti-reflective film 22 may be formed substantially over the entire front surface of the semiconductor substrate 110, excluding the region corresponding to the first electrode 24. The anti-reflective film 22 reduces reflection of light incident upon the front surface of the semiconductor substrate 110 and passivates defects present on the surface or in the bulk of the emitter layer 20.

By reducing reflection of light incident upon the front surface of the semiconductor substrate 110, an amount of light which reaches the p-n junction formed at the boundary between the semiconductor substrate 110 and the emitter layer 20 is increased. Accordingly, a short-circuit current (Isc) of the solar cell 150 is increased. In addition, defects present in the emitter layer 20 are passivated, recombination sites of minority carriers are removed and an open-circuit voltage (Voc) of the solar cell 150 is thus increased. As such, the open-circuit voltage and the short-circuit current of the solar cell 150 are increased by the anti-reflective film 22 and efficiency of the solar cell 150 is thus increased.

The anti-reflective film 22 may be formed of various materials. For example, the anti-reflective film 22 may have a single film structure including one selected from the group consisting of a silicon nitride film, a silicon nitride film containing hydrogen, a silicon oxide film, a silicon oxide nitride film, an aluminum oxide film, MgF₂, ZnS, TiO₂ and CeO₂, or a multi-film structure including two or more films thereof. However, the embodiments of the invention are not limited to the structure of the anti-reflective film 22 and the anti-reflective film 22 may comprise various materials. A separate front passivation film may be further provided for passivation between the semiconductor substrate 110 and the anti-reflective film 22. This also falls within the scope of the embodiments of the invention.

The first electrode 24 is electrically connected to the emitter layer 20 through an opening formed on the anti-reflective film 22 (that is, while passing through the anti-reflective film 22). The first electrode 24 may be formed in various shapes using various materials. For example, the second electrode 24 includes a plurality of finger electrodes disposed in parallel and bus bar electrodes to connect the finger electrodes.

A rear electric field layer 30 comprising a first conductivity type impurity in a higher doping concentration than the semiconductor substrate 110 is formed on the rear surface of the semiconductor substrate 110. The present drawing illustrates that the electric field layer 30 has a structure in which a doping concentration of the first conductivity type impurity is predominantly homogeneous. However, the embodiments of the invention are not limited to this structure and the electric field layer 30 may have a selective structure including a high-concentration doping region and a low-concentration doping region. Other variations in structure are possible.

The passivation film 32 and the second electrode 34 may be formed on the rear surface of the semiconductor substrate 110.

The passivation film 32 may be formed substantially over the entire rear surface of the semiconductor substrate 110, excluding the region where the second electrode 34 is formed. The passivation film 32 passivates defects present on the rear surface of the semiconductor substrate 110 and thereby removes recombination sites of minority carriers. As a result, the open-circuit voltage of the solar cell 150 is increased.

For example, the passivation film 32 may have a single film structure including one selected from the group consisting of a silicon nitride film, a silicon nitride film containing hydrogen, a silicon oxide film, a silicon oxide nitride film, an aluminum oxide film, MgF₂, ZnS, TiO₂ and CeO₂, or a multi-film structure including two or more films thereof. However, the embodiments of the invention are not limited in terms of the structure of the passivation film 32 and the passivation film 32 may comprise various materials.

The second electrode 34 is electrically connected to the rear electric field layer 30 through an opening formed on the passivation film 32 (that is, while passing through the passivation film 32). The second electrode 34 may be formed in various shapes using various materials. The ribbon 142 connected to the second electrode 34 of an adjacent another solar cell 150 is disposed on the first electrode 24 and the ribbon 142 connected to the first electrode 24 of the adjacent another solar cell 150 is disposed on the second electrode 34. The ribbon 142 may be joined to the first or second electrode 24 or 34 by soldering.

The second electrode 34 is, for example, formed by applying a paste composite comprising a conductive material, followed by baking. As described above, in the embodiment of the invention, the rear surface of the semiconductor substrate 110 also has irregularities formed through texturing to reduce reflection. As a result, regions where adhesion of the second electrode 34 to the ribbon 142 is not well performed, since the second electrode 34 does not sufficiently cover the semiconductor substrate 110 due to irregularities of the semiconductor substrate 110. This problem may become more serious when costs are intended to be reduced by decreasing the content of conductive powder in the second electrode 34.

In consideration of this problem, in the embodiment of the invention, the semiconductor substrate 110 can be sufficiently covered with the second electrode 34 by controlling properties of the paste composite for forming the second electrode 34. As a result, exposure of the semiconductor substrate 110 or deterioration in adhesion of the second electrode 34 to the ribbon 142 is prevented or reduced. Hereinafter, a paste composite for forming the second electrode 34 (hereinafter, referred to as "paste composite") which has a low conductive powder content and sufficiently covers irregularities of the semiconductor substrate 110 will be described in detail.

The paste composite according to the embodiment of the invention may further comprise a conductive powder, a glass frit and an organic vehicle, and may further comprise other additives.

The conductive powder may comprise a metal, a conductive polymer material or the like. The metal may be silver, aluminum, gold, copper, or an alloy thereof. The conductive polymer material may be polypyrrole, polyaniline or the like. As the conductive powder, silver having high electric conductivity and superior adhesion to the ribbon 142 may be used.

In the embodiment of the invention, the conductive powder may be present in an amount of 30 to 50 parts by weight, with respect to 100 parts by weight of the paste composite for forming an electrode in total. As such, in the embodiment of the invention, production costs are reduced by decreasing the amount of the conductive powder in the paste composite for forming an electrode. In particular, when expensive silver or the like is used as the conductive powder, production costs can be greatly reduced by controlling the amount of the conductive powder to a level less than 50 parts by weight. When the conductive powder is present in an amount less than 30 parts by weight, electrical conductivity of the produced second electrode 34 may be insufficient due to excessively small amount of the conductive powder.

In the embodiment of the invention, the semiconductor substrate 110 having irregularities can be sufficiently covered by limiting a mean particle diameter of the conductive powder. That is, the semiconductor substrate 110 having irregularities is sufficiently covered by increasing specific surface area through control of the mean particle diameter of the conductive powder, although the conductive powder is present in a low content.

For example, the mean particle diameter of the conductive powder may be 0.3 µm to 1.0 µm. When the mean particle diameter is lower than 0.3 µm, a gap between the conductive powder particles is decreased, a space into which organic substances permeate is narrow, and dispersion is not smooth. In addition, the gap between the conductive powder particles is decreased, but a total volume ratio of the gap is increased and a rough surface of the semiconductor substrate 110 may not be sufficiently covered. In addition, when the mean particle diameter is less than 0.3 µm, it is difficult to produce the conductive powder, and thus, the conductive powder is expensive. When the mean particle diameter exceeds 1.0 µm, a specific surface area of the conductive powder is small and the second electrode 34 does not sufficiently cover the semiconductor substrate 110 when the conductive powder is present in a low content.

The conductive powder may have various shapes such as spherical shape or non-spherical shape (for example, plate-, bell- or flake-type). For the spherical shape powder, the mean particle diameter of the conductive powder is obtained, based on a particle diameter thereof, and for the non-spherical shape powder, the mean particle diameter of the conductive powder is obtained, based on a length of a long side. As the conductive powder, a single particle or a combination of particles having different particle diameters may be used.

In the embodiment of the invention, the glass frit may have a glass transition temperature (Tg) enabling improvement of adhesion to the ribbon 142. That is, adhesive strength between the electrode and the ribbon 142 is improved by controlling a glass transition temperature of the glass frit, instead of reducing the content of the conductive powder. More specifically, deterioration in adhesive strength caused by decrease in conductive powder content is offset using a glass frit having a relatively lower glass transition temperature.

For example, the glass transition temperature of the glass frit may be 280°C to 350°C. When the glass transition temperature of the glass frit exceeds 350°C, adhesive strength to the ribbon 142 may be deteriorated, and when the glass transition temperature is lower than 280°C, the glass frit is readily crystallized and thus cannot maintain the glass state.

There are various methods for imparting the glass transition temperature described above to the glass frit. For example, a desired glass transition temperature can be imparted to the glass frit by controlling a composition of the glass frit. Specifically, in the embodiment of the invention, the glass frit is a lead-free glass frit containing no lead (Pb), and comprises a substance containing bismuth (Bi) (for example, bismuth, or oxides, fluorides, nitrides, sulfides or phosphates containing bismuth) as a main component and a substance comprising silicon (Si), aluminum (Al), barium (Ba), boron (B), zinc (Zn), phosphorus (P), lithium (Li), sodium (Na), tellurium (Te), calcium (Ca), tin (Sn), copper (Cu), molybdenum (Mo), cerium (Ce) or manganese (Mn) (for example, these elements, or oxides, fluorides, nitrides, sulfides or phosphates containing these elements) as other component. The main component is contained in an amount of at least 50 parts by weight. In the embodiment of the invention, the bismuth-containing substance is present in an amount of 50 parts by weight or more.

More specifically, in the embodiment of the invention, for example, the glass transition temperature of the glass frit is adjusted to 280°C to 350°C through use of the bismuth-containing substance (for example, bismuth oxide) in an amount of 70 to 90 parts by weight. However, the embodiments of the invention are not limited thereto and the glass transition temperature of the glass frit may be controlled using various methods.

The glass frit may be present in an amount of 1 to 5 parts by weight, with respect to 100 parts by weight of the total paste composite. The glass frit improves adhesive strength, ease of sintering and post-processing properties of the solar cell 150 within the range of 1 to 5 parts by weight.

The organic vehicle is obtained by dissolving a binder in a solvent and may further comprise a defoaming agent, a dispersant or the like. The solvent may be an organic solvent such as terpineol or carbitol. The binder may be a cellulose binder.

The organic vehicle may be present in an amount of 45 parts by weight to 69 parts by weight, with respect to 100 parts by weight of the total paste composite. When the organic vehicle is present in an amount exceeding 69 parts by weight, electrical conductivity of the second electrode 34 may be decreased. When the organic vehicle is present in an amount of less than 45 parts by weight, an amount of the conductive powder is relatively great and costs of the paste composite are increased. However, the embodiments of the invention are not limited to the amount of the organic vehicle and the amount of the organic vehicle may be changed according to amounts of the glass frit and the conductive powder.

The paste composite may further comprise a thixotropic agent, a leveling agent, a defoaming agent or the like as other additives. The thixotropic agent may be a polymer (organic substance) such as urea, amide or urethane, inorganic silica, or the like.

The paste composite may be prepared by the following method.

A binder is dissolved in a solvent and pre-mixing is performed to prepare an organic vehicle. A conductive powder, a glass frit and an additive are added to the organic vehicle and the resulting mixture is aged for a predetermined time. The aged mixture is mechanically mixed and dispersed using a 3-roll mill or the like. The mixture is filtered and defoamed to prepare a paste composite. This method is provided only as an example and the embodiments of the invention are not limited to the example.

The prepared paste composite is applied to a semiconductor substrate 110 by various methods (for example, screen printing), followed by baking, to form the second electrode 34.

The paste composite according to the embodiment of the invention enables reduction of production costs due to low conductive powder content. By controlling the mean particle diameter of the conductive powder and glass transition temperature of the glass frit, the property of covering the semiconductor substrate 110 is improved and adhesion to the ribbon 142 is also enhanced. That is, when the paste composite of the embodiment of the invention is used, the content of the conductive powder is lowered, adhesion is improved, and the second electrode 34 with superior properties can be manufactured at low cost. For example, the second electrode 34 produced using the paste composite according to the embodiment of the invention has a high adhesive strength of 3.78N or more when the adhesive strength is measured by pulling at a rate of 5m/sec using a pullout tester. For example, the adhesive strength may be 4.75N to 4.96N.

The description given above is directed to the paste composite for forming the second electrode 34 disposed on the rear surface of the semiconductor substrate 110. This is based on an assumption that the second electrode 34 disposed on the rear surface of the semiconductor substrate 110 has similar or lower effects on efficiency of solar cells, as compared to the first electrode 24. However, the paste composite of the embodiment of the invention may be used as a paste composite for formation of the first electrode 24 disposed on the front surface of the semiconductor substrate 110. In addition, the paste composite of the embodiments of the invention may be applied to various other fields.

Hereinafter, the embodiments of the invention will be described in more detail with reference to the following examples. However, the examples are provided only for illustration of the embodiments of the invention and are not to be construed as limiting the scope of the embodiments of the invention.

### Example 1

A binder was dissolved in a solvent to prepare an organic vehicle. The solvent used herein was α-terpineol and the binder used herein was a cellulose binder. A conductive powder, a glass frit and an additive were added to the organic vehicle, followed by pre-mixing. The mixture was aged for 12 hours and was then secondarily mixed and dispersed using a 3-roll mill. The mixture was filtered and defoamed to prepare a paste composite.

The paste composite comprised 58 parts by weight of the organic vehicle, 40 parts by weight of the conductive powder, and 2 parts by weight of the glass frit. The conductive powder comprised a silver powder having a mean particle diameter of 0.3 µm and the glass frit had a glass transition temperature of 326°C.

The paste composite was applied, using a printing method, onto a semiconductor substrate having irregularities formed by texturing, followed by baking, to form an electrode.

### Example 2

An electrode was formed in the same manner as in Example 1, except that the mean particle diameter of the silver powder used as the conductive powder was 0.5 µm.

### Example 3

An electrode was formed in the same manner as in Example 1, except that the mean particle diameter of the silver powder used as the conductive powder was 0.8 µm.

### Example 4

An electrode was formed in the same manner as in Example 1, except that the mean particle diameter of the silver powder used as the conductive powder was 1.0 µm.

### Comparative Example 1

An electrode was formed in the same manner as in Example 1, except that the mean particle diameter of the silver powder used as the conductive powder was 0.2 µm.

### Comparative Example 2

An electrode was formed in the same manner as in Example 1, except that the mean particle diameter of the silver powder used as the conductive powder was 1.5 µm.

### Comparative Example 3

An electrode was formed in the same manner as in Example 1, except that the mean particle diameter of the silver powder used as the conductive powder was 3.0 µm.

### Comparative Example 4

A rear electrode was formed in the same manner as in Example 3 except that the glass transition temperature of the glass frit was 272°C.

### Comparative Example 5

A rear electrode was formed in the same manner as in Example 3 except that the glass transition temperature of the glass frit was 382°C.

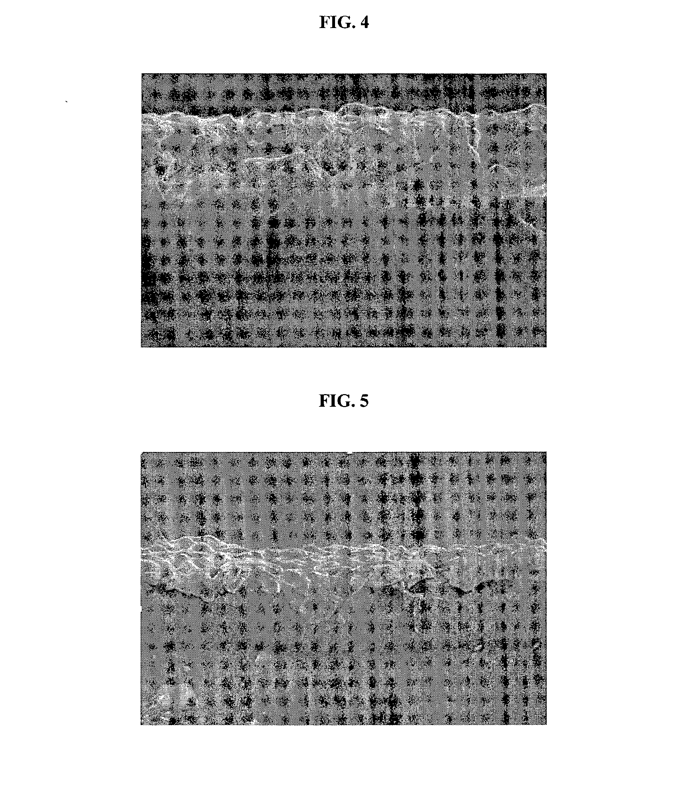

A ribbon (60% by weight of tin and 40% by weight of lead) was adhered to each electrode formed in accordance with Examples 1 to 4 and Comparative Examples 1 to 5 through soldering, the electrode was pulled out at a rate of 5m/sec using a pull-out tester and adhesive strength was measured. Whether irregularities of the semiconductor substrate were exposed to a region where the electrode was formed, was checked. A case in which the irregularities of the semiconductor substrate were not exposed was considered indicative of good covering properties and a case in which at least some irregularities of the semiconductor substrate were exposed was considered indicative of bad covering properties. Test results of adhesive strength and covering property are shown in Table 1. Scanning electron micrographs (SEMs) of cross-sections of semiconductor substrates and rear electrodes in accordance with Examples 2 and 3, and Comparative Examples 2 and 3 are shown in FIGS 4 to 7.

**TABLE 1**

| | Adhesive strength [N] | Covering property |
|---|---|---|
| Ex. 1 | 3.78 | good |
| Ex. 2 | 4.75 | good |
| Ex. 3 | 4.96 | good |
| Ex. 4 | 4.32 | good |
| Comp. Ex. 1 | 2.24 | bad |
| Comp. Ex. 2 | 1.89 | bad |
| Comp. Ex. 3 | 0.96 | bad |
| Comp. Ex. 4 | 0.87 | bad |
| Comp. Ex 5 | 2.45 | bad |

As can be seen from Table 1, the electrodes in accordance with Examples 1 to 4 had high adhesive strength of 3.78N or more (in particular, electrodes in accordance with Examples 2 and 3 having a mean particle diameter of a silver powder of 0.5 µm to 0.8 µm had a 4.75N or more). On the other hand, in Comparative Examples 1 to 5, the electrodes had considerably low adhesive strength of 2.45N or less. In addition, in Examples 1 to 4, the entirety of the irregularities of the semiconductor substrate was sufficiently covered and covering properties were thus good. In comparative Examples 1 to 5, irregularities of the semiconductor substrate were exposed to the outside and covering properties were thus poor.

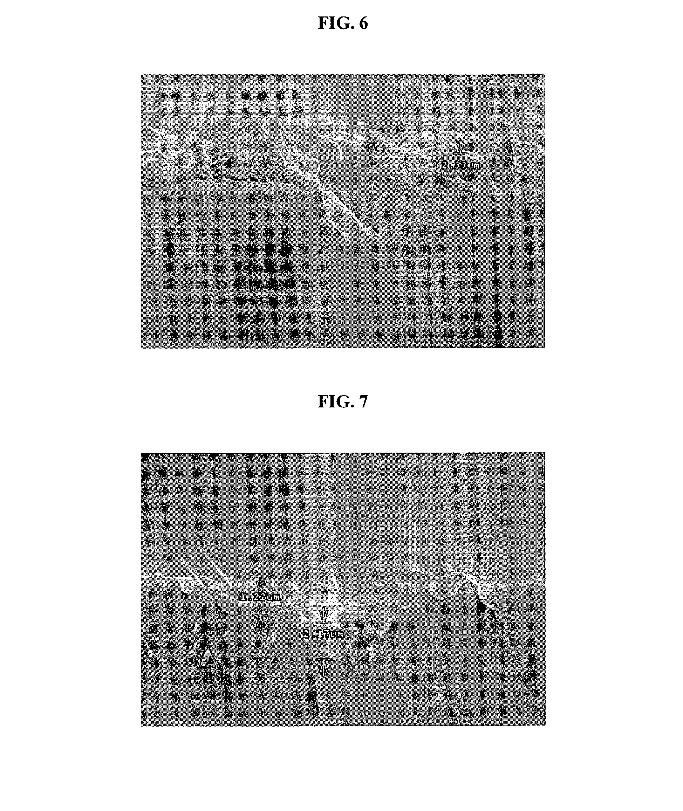

In addition, as can be seen from FIGS. 4 and 5, in Examples 2 and 3, the electrodes were formed so as to cover the irregularities of the semiconductor substrate and covering properties were thus good. On the other hand, as can be seen from FIGS. 6 and 7, in Comparative Examples 2 and 3, irregularities of the semiconductor substrate were exposed to the outside and the electrode thus did not entirely cover the semiconductor substrate.

The features, structures and effects illustrated in the above embodiments may be included in at least one embodiment of the invention but are not limited to one embodiment. Further, those skilled in the art will appreciate that various combinations and modifications of the features, structures and effects illustrated in the respective embodiments are possible. Therefore, it will be understood that these combinations and modifications are covered by the scope of the invention.

## Claims

1. A paste composite for forming an electrode of a solar cell, the paste composite comprising:
a conductive powder;
a glass frit; and
an organic vehicle,
wherein the conductive powder is present in an amount of 50 parts by weight or less, with respect to 100 parts by weight of the paste composite in total, and
the conductive powder has a mean particle diameter of 0.3 µm to 1.0 µm.

2. The paste composite according to claim 1, wherein the mean particle diameter of the conductive powder is 0.5 µm to 0.8 µm.

3. The paste composite according to claim 1, wherein a glass transition temperature (Tg) of the glass frit is 280°C to 350°C.

4. The paste composite according to claim 3, wherein the glass frit is a lead-free glass frit and comprises a bismuth-containing substance.

5. The paste composite according to claim 4, wherein the bismuth-containing substance is bismuth, or oxide, fluoride, nitride, sulfide or phosphate containing bismuth.

6. The paste composite according to claim 4, wherein the glass frit comprises 70 to 90 parts by weight of the bismuth-containing substance, with respect to 100 parts by weight of the glass frit.

7. The paste composite according to claim 1, wherein the conductive powder is present in an amount of 30 to 50 parts by weight, with respect to 100 parts by weight of the paste composite in total.

8. The paste composite according to claim 1, wherein the conductive powder comprises a silver powder.

9. The paste composite according to claim 1, wherein the glass frit is present in an amount of 1 to 5 parts by weight, with respect to 100 parts by weight of the paste composite in total.

10. The paste composite according to claim 1, wherein the organic vehicle is present in an amount of 45 to 69 parts by weight, with respect to 100 parts by weight of the paste composite in total.

11. The paste composite according to claim 1, wherein the paste composite is used for a rear electrode of the solar cell.
